# EUROPEAN PATENT SPECIFICATION

(11) **EP 1 095 387 B1**
(45) Date of publication and mention of the grant of the patent: **03.03.2004**
(21) Application number: 99957110.2
(22) Date of filing: 15.06.1999
(51) Int. Cl.: H01G 9/20

(54) **REVERSED DYE-SENSITIZED PHOTOVOLTAIC CELL**
REVERSES FARBSTOFF-SENSIBILISIERTES PHOTOVOLTAISCHES MODUL
CELLULE PHOTOVOLTAIQUE INVERSEE SENSIBILISEE AU COLORANT

(30) Priority: 18.06.1998 NL 1009431
(43) Date of publication of application: 02.05.2001
(73) Proprietor: Stichting Energieonderzoek Centrum Nederland(ECN), 1755 ZG Petten (NL)
(72) Inventor: VAN ROOSMALEN, Johannes, Adrianus, Maria, NL-1826 GG Alkmaar (NL); RIJNBERG, Evelien, NL-1019 NN Amsterdam (NL); SOMMELING, Paul, Matthieu, NL-2316 XV Leiden (NL)
(74) Representative: Dokter, Hendrik Daniel
(86) International application number: PCT/NL1999/000371
(87) International publication number: WO 1999/066520

(56) References cited:
- EP-A- 0 855 726
- WO-A-97/15959
- US-A- 4 927 721
- US-A- 5 350 644

## Description

The invention relates to a photovoltaic element comprising a layered structure of at least a first electrically conductive layer, a layer of crystalline metal oxide semiconductor material deposited on the first electrically conductive layer, a layer of a photosensitization material deposited on the semiconductor material, a transparent second electrically conductive layer deposited on a transparent substrate and an electrolytic liquid contained between the layer of semiconductor material and the second electrically conductive layer.

Such an element is known from the American patent no. 4,927,721. This patent discloses a photo-electrochemical cell comprising a polycrystalline metal oxide semiconductor layer having a substantially monomolecular chromophore layer in a surface zone. The metal oxide semiconductor layer is a TiO₂-layer having a roughness factor of preferably more than 200, deposited on a Ti-substrate. The TiO₂-layer is obtained by a process which is repeated several times, according to which a titanium-ethoxide solution in methanol is applied to the titanium substrate, after which the resulting titanium alkoxide is hydrolized and heated.

Known from the American patent no. 5,350,644 is a photovoltaic cell, which comprises a light-transmitting electrically conductive layer which is deposited on a glass plate or a transparent polymer foil to which a number of preferably porous layers of titanium dioxide have been applied and wherein at least the last titanium dioxide layer is doped with a divalent or trivalent metal ion. The combination of titanium dioxide and conductive layer forms the photoelectrode of a solar cell, which solar cell further comprises a light-transmitting second electrically conductive layer which is deposited on a light-transmitting substrate and which forms a counter-electrode. Received between photoelectrode and counter-electrode is an electrolyte acting as redox system. The operation of the known solar cell is as follows. A photon from the visible light incident via the counter-electrode releases an electron at the interface of titanium dioxide and electrolyte from an electron-hole combination, which electron disappears in the conduction band of the titanium dioxide and is discharged via the electrically conductive layer of the photoelectrode. The resulting hole is supplemented with an electron from the electrolyte, while the electrolyte accepts an electron from the counter-electrode. The acceptance of electrons by the electrolyte can be enhanced by a catalyst applied to the surface of the counter-electrode, while the efficiency of the solar cell can be increased by a sensitizer dye on the surface of the titanium dioxide layer, which dye absorbs light and herein acquires an energy-rich state and is able to inject an electron with an efficiency of almost 100% into the conduction band of the titanium dioxide.

The solar cells known form the latter patent have a number of disadvantageous properties which stand in the way of large-scale application of this cell. Inherent in the use of glass as transparent substrate material is a determined thickness of a solar cell which makes the cell unsuitable for use for instance in particular products in the field of consumer electronics, such as watches. It is known that replacing glass with a transparent plastic results in a loss of efficiency of the solar cell.

It is an object of the invention to provide a solar cell of very small thickness which has a high efficiency when transparent polymer foil is used as substrate material and which can be assembled in large quantities in simple manner.

This objective is achieved and other advantages gained with a photovoltaic element of the type stated in the preamble, wherein according to the invention the photovoltaic element is flexible, the semiconductor material deposited on the first conductive layer is sintered, a catalyst layer is provided, the first conductive layer is a zinc or titanium foil, which zinc or titanium foil is provided with a skin of its oxide, and the transparent substrate is a foil of flexible plastic material.

In the solar cell according to the invention light impinges upon the semiconductor material via the transparent counter-electrode and the electrolytic liquid between the counter-electrode and the semiconductor material. The most obvious manner of light incidence in the known cell, i.e. via the photoelectrode, is precluded by use of the non-transparent metal foil. A photovoltaic element according to the invention is a "reversed solar cell".

Surprisingly, it has now been found that the efficiency of a reversed solar cell according to the invention is higher than in a known, above described solar cell, wherein the photoelectrode is impinged upon directly, and not via the electrolytic liquid, by the photons of incident sunlight. The cause of the recorded increase in efficiency is sought in the fact that application of a metal foil as substrate material enables sintering of the layer of semiconductor material at higher temperatures than in a known solar cell with a substrate of polymer material.

With the use of a zinc or titanium foil a skin of zinc oxide respectively titanium oxide results when the semiconductor layer deposited thereon is sintered, which skin on the one hand forms a protection for the underlying zinc respectively titanium foil and on the other forms a good electrical conductor owing to its photoelectric properties.

The semiconductor material in a photovoltaic element according to the invention is for instance zinc oxide, tin oxide or, preferably, titanium dioxide.

The foil of flexible plastic material in a photovoltaic element according to the invention in an advantageous embodiment is polyethylene terephthalate (PET).

The invention will now be elucidated hereinbelow on the basis of embodiments and with reference to the drawings.

In the drawings

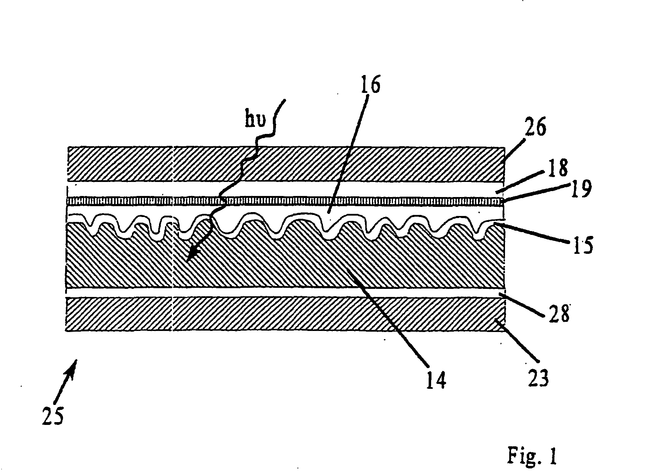

Fig. 1 shows in schematic cross-section an embodiment of a solar cell according to the invention.

Fig. 1 shows the layered structure of a solar cell 25, which is substantially built up of a titanium foil 23, a porous layer of nanocrystalline titanium dioxide 14, a layer 15 of a suitable dye-sensitizer, a lithium iodide/iodine solution 16 and a flexible foil 26 of PET on which a layer 18 of a transparent conductive oxide (TCO) is deposited. Layer 15 is shown in greatly simplified manner. In reality the dye-sensitizer is applied in a solution to semiconductor layer 14 and penetrates into the pores thereof, so that the dye covers the whole semiconductor surface. The layer of titanium dioxide 14 is formed in accordance with a per se known method by sintering a dispersion of colloidal particles of titanium dioxide onto titanium foil 23, wherein between the sintered titanium dioxide 14 and titanium foil 23 a layer of titanium dioxide 28 results which protects the underlying layer 23 against the corrosive action of the lithium iodide 16. The figure further shows a layer 19 (not shown to scale) of a catalyst, for instance carbon, for the conversion of neutral I in the lithium iodide solution to I-by accepting an electron from counter-electrode 18. In this solar cell 22 light (indicated by arrows designated hν, wherein h represents Planck's constant and ν the frequency of the incident light) is incident on dye layer 15 via counter-electrode assembly 26, 18, 19 and the lithium iodide solution 16. According to this embodiment, a flexible and very thin solar cell is obtained.

It is noted that the examples given here serve to elucidate the invention, not to limit the scope thereof which is defined by the appended claims. A "reversed" dye-sensitized solar cell according to the invention can for instance also contain, instead of the above mentioned lithium iodide, another per se known suitable electrolyte such as potassium bromide or potassium iodide.

## Claims

1. Photovoltaic element comprising a layered structure (22, 25) of at least
a first electrically conductive layer (23),
a layer of crystalline metal oxide semiconductor material (14) deposited on the first electrically conductive layer (23),
a layer of a photosensitization material (15) deposited on the semiconductor material (14),
a transparent second electrically conductive layer (18) deposited on a transparent substrate (26), and
an electrolytic liquid (16) contained between the layer of semiconductor material (14) and the second electrically conductive layer (18), **characterized in that** the photovoltaic element is flexible, the semiconductor material (14) deposited on the first conductive layer (23) is sintered, a catalyst layer (19) is provided, the first conductive layer (23) is a zinc or titanium foil (23), which zinc or titanium foil is provided with a skin (28) of its oxide, and the transparent substrate is a foil of flexible plastic material (26).

2. Photovoltaic element as claimed in claim 1, **characterized in that** the semiconductor material (14) is zinc oxide or tin oxide.

3. Photovoltaic element as claimed in any of the claims 1-2, **characterized in that** the semiconductor material (14) is titanium dioxide.

4. Photovoltaic element as claimed in any of the foregoing claims, **characterized in that** the photosensitization material (15) comprises a photo-sensitive dye.

5. Photovoltaic element as claimed in any of the foregoing claims, **characterized in that** the plastic material is polyethylene terephthalate (PET) (26).

## Patentansprüche

1. Photovoltaisches Element, das eine Schichtstruktur (22, 25) von zumindest
einer ersten elektrisch leitenden Schicht (23),
einer auf der ersten elektrisch leitenden Schicht (23) aufgetragenen Schicht von kristallinem Metalloxid-Halbleitermaterial (14),
einer auf dem Halbleitermaterial (14) aufgetragenen Schicht Photosensibilisierungsmaterial (15),
einer auf einem transparenten Substrat (26) aufgetragenen, transparenten zweiten elektrisch leitenden Schicht (18), und
einer sich zwischen der Schicht Halbleitermaterial (14) und der zweiten elektrisch leitenden Schicht (18) befindenden Elektrolytflüssigkeit (16) umfasst, **dadurch gekennzeichnet, dass** das photovoltaische Element flexibel ist, das auf der ersten leitenden Schicht aufgetragene Halbleitermaterial (14) gesintert ist, eine Katalysatorschicht (19) verschafft worden ist, die erste leitende Schicht (23) eine Zink- oder Titanfolie (23) ist und diese Zink- oder Titanfolie mit einer Haut (28) seines Oxids versehen ist, und das transparente Substrat eine Folie aus flexiblem Kunststoffmaterial (26) ist.

2. Photovoltaisches Element nach Anspruch 1, **dadurch gekennzeichnet, dass** das Halbleitermaterial (14) Zinkoxid oder Zinnoxid ist.

3. Photovoltaisches Element nach Anspruch 1, **dadurch gekennzeichnet, dass** das Halbleitermaterial (14) Titandioxid ist.

4. Photovoltaisches Element nach einem der obigen Ansprüche, **dadurch gekennzeichnet, dass** das Photosensibilisierungsmaterial (15) einen photosensiblen Farbstoff umfasst.

5. Photovoltaisches Element nach einem der obigen Ansprüche, **dadurch gekennzeichnet, dass** das Kunststoffmaterial Polyethylenterephthalat (PET) (26) ist.

## Revendications

1. Elément photovoltaïque comprenant une structure stratifiée (22, 25) composée d'au moins:
une première couche électriquement conductrice (23),
une couche de matière semi-conductrice d'oxyde de métal cristallin (14) déposée sur la première couche électriquement conductrice (23),
une couche de matière de photosensibilisation (15) déposée sur la matière semi-conductrice (14),
une deuxième couche électriquement conductrice transparente (18) déposée sur un substrat transparent (26), et
un liquide électrolytique (16) contenu entre la couche de matière semi-conductrice (14) et la deuxième couche électriquement conductrice (18), **caractérisé en ce que** l'élément photovoltaïque est flexible, la matière semi-conductrice (14) déposée sur la première couche conductrice (23) est agglomérée, un couche de catalyseur (19) est prévue, la première couche conductrice (23) est une feuille de zinc ou de titane (23), ladite feuille de zinc ou de titane étant pourvue d'une pellicule (28) de son oxyde, et le substrat transparent est une feuille constituée d'une matière plastique flexible (26).

2. Elément photovoltaïque suivant la revendication 1, **caractérisé en ce que** la matière semi-conductrice (14) est de l'oxyde de zinc ou de l'oxyde d'étain.

3. Elément photovoltaïque suivant la revendication 1, **caractérisé en ce que** la matière semi-conductrice (14) est du dioxyde de titane.

4. Elément photovoltaïque suivant l'une quelconque des revendications précédentes, **caractérisé en ce que** la matière de photosensibilisation (15) comprend un colorant photosensible.

5. Elément photovoltaïque suivant l'une quelconque des revendications précédentes, **caractérisé en ce que** la matière plastique est du polyéthylène téréphtalate (PET) (26).
